# EUROPEAN PATENT SPECIFICATION

(11) **EP 0 364 565 B1**
(45) Date of publication and mention of the grant of the patent: **16.08.1995**
(21) Application number: 89904859.9
(22) Date of filing: 05.04.1989
(51) Int. Cl.: H03K 23/58, H03K 21/16, H03K 23/50

(54) **SYNCHRONOUS LOGIC CIRCUIT WITH TRANSFER SIGNAL CONTROL**
SYNCHRONER LOGISCHER SCHALTKREIS MIT ÜBERTRAGUNGSSIGNALSTEUERUNG
CIRCUIT LOGIQUE SYNCHRONE AVEC COMMANDE DES SIGNAUX DE TRANSFERT

(30) Priority: 05.04.1988 NL 8800860
(43) Date of publication of application: 25.04.1990
(73) Proprietor: Philips Electronics N.V., 5621 BA Eindhoven (NL)
(72) Inventor: VINK, Hendrik, Adrianus, NL-5621 BA Eindhoven (NL); DEKKER, Robertus, Wilhelmus, Cornelis, NL-5621 BA Eindhoven (NL); THIJSSEN, Aloysius, Petrus, NL-Pijnacker (NL)
(74) Representative: Faessen, Louis Marie Hubertus
(86) International application number: NL8900018
(87) International publication number: WO8910028

(56) References cited:
- EP-A- 0 212 589
- US-A- 3 631 350
- US-A- 3 753 127
- PATENT ABSTRACTS OF JAPAN, vol. 6, no. 155 (E-125)(1033) 17 August 1982 & JP-A-5776927

## Description

The invention relates to a synchronous logic circuit being formed of a series connection of a plurality of logic stages Each logic stage receives a clock signal. In the series connection, each next one of the logic stages comprises a first logic element for receiving a data signal which is derived, from a carry signal being produced by a logic stage, preceding said next one in the series connexion, to produce an intermediate data signal, and a second logic element for receiving the carry signal from the logic stage, preceding said next one in the series connection, and for receiving the intermediate data signal to logically combine the carry signal with the intermediate signal for producing a carry signal provided to a logic stage, succeeding the next one in the series connection.

A circuit of this kind, consisting of several stages, is known from U.S. patent 4,679,216. This patent describes a synchronous counter which is composed of a number of cascade connected jk flipflops which all receive a clock signal ck. In order to increase the counting speed of this synchronous counter, the outputs of the flipflops preceding a flipflop are connected to the input thereof via a logic AND-gate. Such a step ensures that a carry signal, arising due to a counting operation performed by a flipflop and occurring at its output needs not first activate a succession of flipflops in order to activate ultimately a flipflop situated further down the cascade connection. If the logic AND-gates were not used, the carry signal would have to propagate itself as a ripple signal through the cascade connection of the flipflops. Therefore, activation of a flipflop at the end of the cascade connection would be delayed by a number of response times equal to the number of preceding flipflops. The foregoing implies that all outputs of the flipflop circuits are in a steady, desired state only after the ripple signal has reached the last flipflop in the series connection. It is only after this desired state has been reached that a next counting pulse may be applied in order to make the cascade connection of flipflop circuits perform a next counting operation. Tolerating a ripple signal in a logic circuits with a plurality of stages in order to perform a further operation in a subsequent stage in dependence on an operation executed in a preceding stage substantially limits the operating speed of the logic circuit and hence also limits a clock pulse frequency when such a circuit is used in a synchronously operating digital signal processing system.

In order to maintain a high speed of operation (= counting speed), according to aforesaid U.S. patent 4,679,216 the outputs of each preceding flipflop are connected to the input of a subsequent flipflop via a logic gate circuit, so that the last flipflop in the cascade connection is activated as if it were simultaneously with the preceding flipflops. It has been found that this step is very effective and results in a counter circuit which is capable of counting pulses at a very high speed. However, if such a counter consists of a very large number of cascade connected flipflops, the gate circuit to be added for each flipflop is also very extensive. The gate circuit ultimately appears to be a drawback because it becomes very extensive for the last flipflops of the row; this is objectionable because each bit to be added to the counting capacity requires an increasingly larger integration surface area on a semiconductor substrate with respect to the counting flipflop, so that it increasingly tends to limit the counting speed of the counter, because a logic gate is slower as its number of inputs increases.

U.S. patent 3,631,350 discloses an electronic device with first and second cascades of clocked multiple-input J-K flipflops, wherein the flipflops in the second cascade receive a signal from the first cascade in parallel via a clocked multiple-input further J-K flipflop. The further flipflop receives the output signals of flipflops of the first cascade in parallel. A drawback of this embodiment again is the large number of signal leads and the absence of a modular architecture.

It is an object of the invention to provide a logic circuit with a plurality of cascade-connected logic stages in which no extensive logic gate circuits are required for the processing of the higher-order bits and in which the occurrence of ripple signals is tolerated without substantial limitations being imposed as regards a clock pulse frequency by the logic circuit.

To achieve this, a circuit in accordance with the invention is characterized in that at least a particular one of the logic stages comprises a clock controlled storage element for transfer of the carry signal from the logic stage, preceding the particular one of the logic stages in the series connection, to the second logic element of the particular one of the logic stages.

By insertion of a storage element so that, for example, after the appearance of a clock pulse for the control of the logic stages a ripple signal is blocked after having partly traversed the ripple path, a steady state is always realized despite the tolerating of carry signals propagating from one stage to another as a ripple signal with delays so that the logic circuit is suitable for use in a system synchronized by means of clock pulses. The clock frequency is substantially higher than in a network in which the carry signal propagates without obstruction as a ripple signal through all parts of the carry signal path.

A carry signal in the sense of the invention can propagate from components which process the least-significant bits to components which process the more significant bits but also vice versa. A simple example in this respect is a comparator which compares multi-bit words and in which the comparison of two bits of the same significance can generate a carry signal which propagates optionally in the direction of the lower-order bits or in the direction of the higher-order bits (for example, in order to obtain a comparison result more quickly).

The invention will be described by way of example and in more detail with reference to a diagrammatic drawing, therein

Fig. 1 shows a synchronous counter in accordance with the invention, and

Fig. 2 shows a flipflop circuit used in the counter shown in Fig. 1.

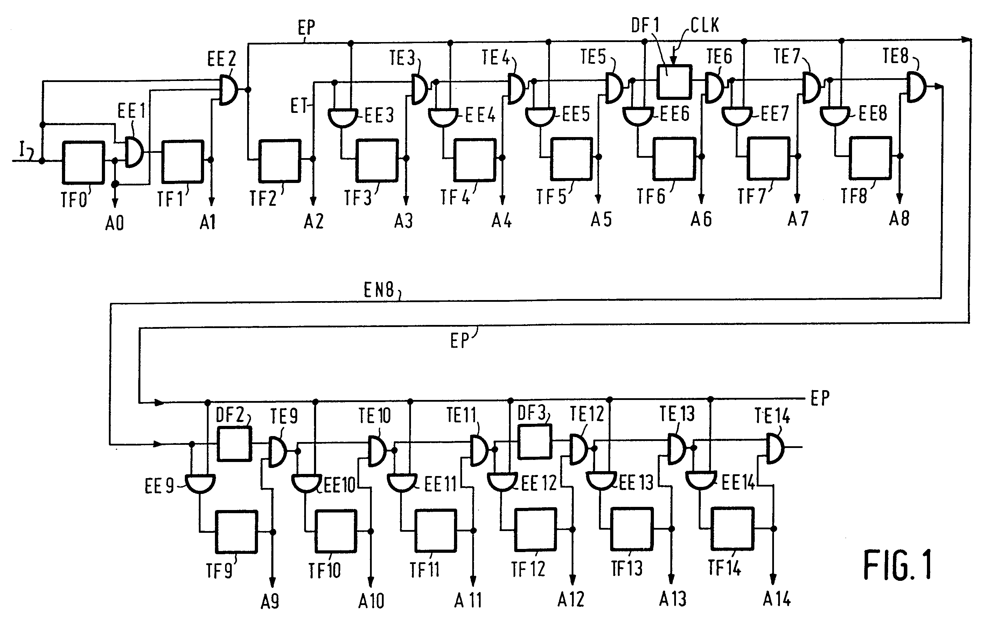

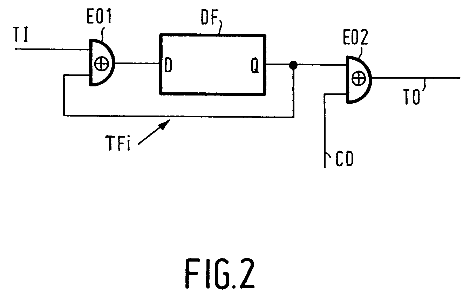

Fig. 1 shows a synchronous counter in accordance with the invention which can act as an address generator for a semiconductor memory. The counter comprises a number of counting flipflops TF0, TF1, ... TF14 and a number of AND-gates EE1, EE2, EE3 to EE14 and a further number of AND-gates TE3, TE4 to TE14. The counter shown in Fig. 1 comprises an input I which is connected to the input of the counting flipflop TF0 and also to an input of the AND-gates EE1 and EE2. The output of the counting flipflop TF0 is connected to a further input the AND-gate EE1 as well as to a further input of the AND-gate EE2. The output of the counting flipflop TF0 forms an address bit A0. The output of the AND-gate EE1 is connected to the input of the second counting flipflop TF1. The output of the counting flipflop TF1 forms the address bit A1 and is also connected to the third input of the AND-gate EE2. The output of the AND-gate EE2 is connected to an input of the counting flipflop TF2 and to an enable line EP whereto all further AND-gates EE3, EE4 etc. to EE14 are connected by way of a first input. The output of the counting flipflop TF2 forms the address bit A2 and a carry signal ET for the next counting flipflop TF3. This carry signal ET is applied, via the AND-gate EE3, to the input of the counting flipflop TF3. The circuit has such a regular construction that the output of the counting flipflop TFi forms the address bit Ai. Furthermore, the output of the counting flipflop TFi is connected, via a carry AND-gate TEi and an enable AND-gate EEi+1, to the input of the counting flipflop TFi+1. In this circuit the variable i can assume the values 3, 4, ... to 14. It is to be noted that not all outputs of the carry AND-gates TEi are directly connected to the inputs of the carry gate TEi + 1. As appears from the Figure, the output signal of the carry AND-gate TE5 is applied, via a storage element in the form of a flipflop DF1, to the carry AND-gate TE6. Similarly, the output of the AND-gate TE8 is applied, via a similar storage element, i.e. the flipflop DF2, to the AND-gate TE9 and the output of the AND-gate TE11 is applied, via a similar storage element, i.e. the flipflop DF3, to the input of the AND-gate TE12. The flipflop circuits used in Fig. 1, i.e. the counting flipflops TF0 to TF14, will be described in detail hereinafter with reference to Fig. 2.

The operation of the synchronous counter shown in Fig. 1 is as follows. The flipflops used in Fig. 1 all receive a clock signal clk. The counter flipflops TF0 to TF14 are so-called toggle flipflops, the pipeline flipflops DF1, DF2 and DF3 being so-called D-flipflops. For as long as the input signal on the input I is high, the logic value of the output of the flipflop TF0 will change in response to each clock pulse. The flipflop TF0, therefore, is a one-bit counter. The combination of the flipflops TF0, TF1, TF2 and the AND-gates EE1 and EE2 constitutes an eight-bit counter. The input I is connected, either directly or via a single AND-gate EE1 or EE2, to the inputs of the flipflop TF0, TF1 and TF2, so that the counting operations in these flipflops take place substantially in parallel. A counting flipflop TFi (where i = 3, 4, 5, 6) will change the logic value of its output signal when a clock signal is received if the output signal of the AND-gate EEi is logic high. The output signal of the AND-gate EE2 should then be logic high, the output signals of the preceding counting flipflops TF3, ..., TFi-1 should also be logic high, like the output of the counting flipflop TF2. This is because the output of the AND-gate EE2 is applied to all AND-gates EE3 to EE14, like the output signal of the counting flipflop TF2, be it that the latter signal is applied, via the series connection of the AND-gates TE3, TE4, etc. to the relevant AND-gates EE4, EE5 etc. In the worst case, via the transport means which all comprise AND-gates, a carry signal would propagate via the series connection of the AND-gates TE3 to TE14 if no D-flipflops DF1, DF2, DF3 were included in this series connection. In order to preclude the occurrence of undesirable logic states on the counting outputs A0 to A14 in response to a next clock pulse, a next clock signal should occur only after the output signal of the counting flipflop TF2 has traversed all AND-gates TE3 to TE14. This substantially limits the counting speed of the synchronous counter. However, a carry signal which traverses the AND-gates TE3, TE4, TE5 as a ripple signal is now taken over by the D-flipflop DF1 in response to the next clock signal, and is only subsequently applied to the following AND-gates TE6, TE7 etc. In response to the subsequent clock signal the carry signal is stored in the D-flipflop DF2 so that it is only subsequently applied to the subsequent AND-gates TE9 to TE11 etc.

As a result of the addition of storage elements in the form of D-flipflops DF1, DF2 and DF3, a steady, desirable logic state is always ensured on the address output terminals A0 to A14, despite the high frequency of a clock signal. As a result of the described step the delay incurred by carry signals while traversing the AND-gates TE3 to TE14 is distributed over a number of clock periods. This enables a high clock frequency. Various groups can be distinguished in the counter shown in Fig. 1. A first group actually operates in parallel and comprises the counting flipflops TF0, TF1 and TF2 which, having only one gate delay, hardly influence the counting speed. A second part concerns a series connection of a number of counting flipflops TF3 to TF14 and a number of AND-gates TE3 to TE14 via which a carry signal must propagate. A carry signal is admitted to a next counting flipflop TFi via a gate EEi by an enable signal on the enable line EP, which enable signal is applied in parallel to all access AND-gates EE3 to EE14. The construction of the synchronous counter shown has the following consequences. The counter itself is very well suitable for use in a synchronous timing organization. A very high counting frequency equal to the clock frequency can be achieved for as long as the delay incurred by the carry signals in the various parts TE3, 4, 5, and DF1, EE3, 4, 5, 6; TE6, 7, 8 and DF2, EE7, 8, 9; TE9, 10, 11 and DF3, EE10, 11, 12 is less than the clock pulse period. Apart from the series connection of the counting flipflops TFi, hardly andy further hardware in the form of logic gates and further flipflops is required and the number of interconnections is limited. Consequently, the counter can be extended so as to form a counter for a larger number of bits. The various parts of the counter, to be distinguished as the parallel part and the serial part which are separated from one another by the pipeline flipflops DF1, DF2, DF3, always contain a correct counting code. It can be simple indicated that a counter has reached its full count and hence enters an overflow state. The pipeline flipflops DF1, DF2, DF3 do not require reset facilities. The counting procedure can be stopped as desired and can be subsequently resumed without any problems. The counting direction can be reversed without problems, as will be described hereinafter, and the setting of an arbitrary counting position of the counter must be followed by a waiting period amounting to a number of clock periods equal to the number of pipeline flipflops, in this case DF1 to DF3. This condition is not applicable when the new position of the counter implies that the stages of the first group, whose carry signal is generated after the second group, start in the very first state of the counting cycle. This is because the enable signal EP dominates the serial transport in the serial group. The number of flipflops in the parallel part should be such that the counting cycle of the parallel part is larger than or equal to the number of the pipeline flipflops DF.

Fig. 2 shows a flipflop TFi of Fig. 1. This flipflop TFi comprises a first EXCLUSIVE-OR gate EO1, a second EXCLUSIVE-OR gate E02 and a D-flipflop DF. A first input of the EXCLUSIVE-OR gate EO1 constitutes the input of the flipflop TFi. The output of the EXCLUSIVE-OR gate EO1 is connected to the D-input of the flipflop DF. The output of the flipflop DF is connected to a first input of the EXCLUSIVE-OR gate EO2 and also to the second input of the EXCLUSIVE-OR gate EO1. The flipflop DF shown forms, together with the EXCLUSIVE-OR gate EO1, a flipflop which is connected as a toggle. The output of the EXCLUSIVE-OR gate EO2 constitutes the output of the flipflop TFi. The second input of the EXCLUSIVE-OR gate EO2 determines the counting direction of the synchronous counter shown in Fig. 1. This second input of the EXCLUSIVE-OR gate EO2 of the flipflop TFi, of course, is connected to inputs of the EXCLUSIVE-OR gates EO2 of the other flipflops TFi of the counter shown in Fig. 1.

For the described embodiments use is made of synchronous counting circuits for the purpose of illustration of the invention. However, the invention can also be used in logic circuits in which operations other than counting operations are performed, for example, addition and multiplication operations (parallel adders, multipliers, etc.). When the invention is used in such circuits, the effective speed of operation will be lower than the maximum speed that can be achieved by means of the clock pulse frequency. However, the effective speed of operation will be substantially higher than a speed of operation to be achieved in, for example a parallel adder in which carry signals can propagate through all adder modules as a ripple signal. An adder circuit in accordance with the invention could be organized as follows. The parallel adder could perform an addition in three steps under the control of clock pulses, a first part of the adder adding two groups (for example, having a width of 8 bits) of least-significant bits and comprising transport means for the propagation of carry signals. The duration of propagation of the carry signals should be shorter than the inverse of the clock pulse frequency. A carry signal, if any, to be assigned to a more-significant bit is stored in a storage element in response to a next clock pulse; this element applies the carry signal to the transport means of a second part of the adder. In response to said next clock signal, two groups of bits having a higher significance are also added in the second part (for example, bits 9 to 16 of words having a width of 24 bits). Similarly, a carry signal, if any, generated int he second part of the adder is applied to a third part of the adder in response to the subsequent clock pulse, which third part adds the groups of most-significant bits. The foregoing illustrates that a stable, desired state always occurs on the output of the three parts, but that the complete result of the addition becomes available only after the third clock pulse. However, in the case of cumulative addition the first part of the adder can already add a part of a next 24 bit word to its content, the second part of the adder adding the central part of the preceding word to be added. This pipeline effect increases the effective speed of operation again.

## Claims

1. A synchronous logic circuit being formed of a series connection of a plurality of logic stages (TFi/TEi; i=3, 4, ..., 14), wherein:
- each logic stage (TFi/TEi) receives a clock signal;
- in the series connection, each next one of the logic stages (TFi/TEi) comprises:
- a first logic element (TFi) for receiving a data signal which is derived from a carry signal being produced by a logic stage, preceding said next one in the series connection, to produce an intermediate data signal (Ai);
- a second logic element (TEi) for receiving the carry signal from the logic stage, preceding said next one in the series connection, and for receiving the intermediate data signal to logically combine the carry signal with the intermediate signal for producing a carry signal provided to a logic stage, succeeding the next one in the series connection;
characterized in that
at least a particular one of the logic stages (TF6/TE6) comprises a clock controlled storage element (DF1) for transfer of the carry signal from the logic stage, preceding the particular one of the logic stages in the series connection, to the second logic element of the particular one of the logic stages.

2. The circuit of claim 1, characterized in that the first logic elements are uniform and in that the second logic elements are uniform.

3. The circuit of claim 2, characterized in that
- each respective one of the first logic elements comprises a respective toggle-flipflop;
- each respective one of the second logic elements comprises a respective AND gate;
- the clock controlled storage element comprises a D-flipflop.

4. The circuit of claim 1, characterized in that each next one of the logic stages comprises a logic enabling gate (EEi; i= 3, 4, ..., 14) between the preceding logic stage and the first logic element of said next logic stage, the logic enabling gate being operative to transfer the data signal to the first logic element in response to a control signal (EP) supplied in parallel to the enabling gates of the plurality of logic stages.

## Patentansprüche

1. Synchrone Logikschaltung, die von einer Reihenschaltung aus einer Vielzahl von Logikstufen (TFi/TEi; i=3, 4, ..., 14) gebildet wird, wobei:
- jede Logikstufe (TFi/TFe) ein Taktsignal empfängt;
- in der Reihenschaltung jede folgende der Logikstufen (TFi/TFe) folgendes umfaßt:
- ein erstes Logikelement (TFi) zum Empfang eines Datensignals, das aus einem von einer Logikstufe, die der genannten folgenden in der Reihenschaltung vorangeht, erzeugten Übertragssignal abgeleitet wird, zur Erzeugung eines Zwischendatensignals (Ai);
- ein zweites Logikelement (TEi) zum Empfang des aus der Logikstufe, die der genannten folgenden in der Reihenschaltung vorangeht, kommenden Übertragssignals und zum Empfang des Zwischendatensignals, um das Übertragssignal mit dem Zwischensignal logisch zu kombinieren, zur Erzeugung eines Übertragssignals, das einer Logikstufe zugeführt wird, die der folgenden in der Reihenschaltung folgt, dadurch gekennzeichnet, daß mindestens eine bestimmte der Logikstufen (TF6/TF6) ein taktgesteuertes Speicherelement (DF1) umfaßt zur Übertragung des Übertragssignals von der Logikstufe, die der bestimmten der Logikstufen in der Reihenschaltung vorangeht, zu dem zweiten Logikelement der bestimmten der Logikstufen.

2. Schaltung nach Anspruch 1, dadurch gekennzeichnet, daß die ersten Logikelemente gleichförmig sind und daß die zweiten Logikelemente gleichförmig sind.

3. Schaltung nach Anspruch 2, dadurch gekennzeichnet, daß
- jedes jeweilige eine der ersten Logikelemente ein jeweiliges Toggle-Flipflop umfaßt;
- jedes jeweilige eine der zweiten Logikelemente ein jeweiliges UND-Gatter umfaßt;
- das taktgesteuerte Speicherelement ein D-Flipflop umfaßt.

4. Schaltung nach Anspruch 1, dadurch gekennzeichnet, daß jede folgende der Logikstufen ein Freigabe-Logikgatter (EEi; i=3, 4, ..., 14) zwischen der vorhergehenden Logikstufe und dem ersten Logikelement der genannten folgenden Logikstufe hat, wobei das Freigabe-Logikgatter in Reaktion auf ein den Freigabegattern von der Vielzahl von Logikstufen parallel zugeführtes Steuersignal (EP) für die Übertragung des Datensignals zum ersten Logikelement sorgt.

## Revendications

1. Circuit logique synchrone formé d'un montage en série d'une pluralité d'étages logiques (TFi/TEi; i = 3, 4, ..., 14), dans lequel :
- chaque étage logique (TFi/TEi) reçoit un signal d'horloge,
- dans le montage en série, chaque étage suivant parmi les étages logiques (TFi/TEi) comprend :
- un premier élément logique (TFi) pour recevoir un signal de données qui est dérivé d'un signal de report produit par un étage logique, précédant ledit étage logique suivant dans le montage en série, pour produire un signal de données intermédiaire (Ai),
- un deuxième élément logique (TEi) pour recevoir le signal de report de l'étage logique, précédant ledit étage logique suivant dans le montage en série et pour recevoir le signal de données intermédiaire afin de combiner logiquement le signal de report avec le signal intermédiaire afin de produire un signal de report délivré à un étage logique, succédant à l'étage logique suivant du montage en série,
caractérisé en ce que :
au moins un étage particulier parmi les étages logiques (TF6/TE6) comprend un élément de stockage (DF1) commandé par des impulsions d'horloge pour le transfert du signal de report de l'étage logique, précédant l'étage particulier des étages logiques du montage en série, au deuxième élément logique de l'étage particulier des étages logiques.

2. Circuit selon la revendication 1, caractérisé en ce que les premiers éléments logiques sont uniformes et en ce que les deuxièmes éléments logiques sont uniformes.

3. Circuit selon la revendication 2, caractérisé en ce que :
- chaque élément respectif des premiers éléments logiques comprend une bascule bistable respective,
- chaque élément respectif des deuxièmes éléments logiques comprend une porte ET respective, et
- l'élément de stockage commandé par les impulsions d'horloge comprend une bascule D.

4. Circuit selon la revendication 1, caractérisé en ce que chaque étage suivant des états logiques comprend une porte de validation logique (EEi; i = 3, 4, ..., 14) entre l'étage logique précédent et le premier élément logique dudit étage logique suivant, la porte de validation logique étant à même de transférer le signal de données au premier élément logique en réaction à un signal de commande (EP) délivré en parallèle aux portes de validation de la pluralité d'étages logiques.
